# EUROPEAN PATENT APPLICATION

(11) **EP 2 693 491 A1**
(43) Date of publication of application: **05.02.2014**
(21) Application number: 12765836.7
(22) Date of filing: 15.03.2012
(51) Int. Cl.: H01L 31/042, B32B 27/32

(54) **PROTECTIVE SHEET FOR SOLAR CELLS, METHOD FOR PRODUCING SAME, AND SOLAR CELL MODULE**

(30) Priority: 30.03.2011 JP 2011074780
(71) Applicant: LINTEC Corporation, Tokyo 173-0001 (JP)
(72) Inventor: NAITOU, Masato, Tokyo 173-0001 (JP); TAKANASHI, Yasunari, Tokyo 173-0001 (JP)
(74) Representative: Raynor, Stuart Andrew
(86) International application number: PCT/JP2012/056670
(87) International publication number: WO 2012/132922

(57) **Abstract**

Solar cell protective sheet 1 comprises a substrate 11 and a thermoplastic resin layer 12 laminated on at least one surface of the substrate 11. The thermoplastic resin layer 12 comprises: a first layer 121 laminated on the substrate 11 and containing as a main component a copolymer of ethylene and at least one selected from the group consisting of (meth)acrylic acid, (meth)acrylic acid ester, glycidyl (meth)acrylate, vinyl acetate and maleic acid anhydride; a second layer 122 laminated on the first layer 121 and containing an olefin-based resin as a main component; and a third layer 123 laminated on the second layer 122 and containing as a main component a copolymer of ethylene and at least one selected from the group consisting of (meth)acrylic acid, (meth)acrylic acid ester, glycidyl (meth)acrylate, vinyl acetate and maleic acid anhydride. The solar cell protective sheet 1 has excellent adhesiveness between the substrate and the thermoplastic resin layer and also has sufficient insulation property.

## Description

### [Technical Field]

The present invention relates to a solar cell protective sheet used as a front surface protective sheet or a back surface protective sheet of a solar cell module and a producing method of the same, and relates also to a solar cell module using the solar cell protective sheet.

### [Background Art]

A solar cell module, which converts the light energy from the sun to electrical energy, attracts attention as a clean energy source capable of generating electricity without emitting carbon dioxide to cope with environmental issues, such as air pollution and global warming.

In general, a solar cell module may be configured of: solar cells, comprised of crystal silicon, amorphous silicon or the like, to perform photoelectric conversion; an encapsulant (filling layer), comprised of an electrical insulator, to encapsulate the solar cells; a front surface protective sheet (front sheet) laminated on the front surface of the encapsulant (light receiving surface); and a back surface protective sheet (back sheet) laminated on the back surface of the encapsulant.

In order for the solar cell module to have weatherability and durability sustainable for long period of time in outdoor and indoor use, it may be required to protect the solar cells and the encapsulant from weather, humidity, fugitive dust, mechanical impact and the like, and avoid the interior of the solar cell module from exposure to the external air thereby to keep hermetically closed state. In addition, if insulation failure occurs in the solar cell module, then a problem may arise that the power generation capability deteriorates. For these reasons, a solar cell protective sheet is required to have weatherability and durability sustainable for long period use as well as sufficient insulation property.

Patent Literature 1 discloses a back surface solar cell protective sheet in which an inorganic oxide layer, an adhesive layer and a thermoplastic resin layer are laminated in this order on one surface of a film. This back surface solar cell protective sheet is applied, via the thermoplastic resin layer, to the encapsulant by being heated and pressed thereon. The film is formed of a resin, such as polyethylene terephthalate, on which silicon oxide layer or the like is vacuum-deposited as the inorganic oxide layer. The adhesive layer is formed of a maleic acid anhydride modified polypropylene resin, and the thermoplastic resin layer is formed of polypropylene.

### [Prior Art Literature]

### [Patent Literature]

[Patent Literature 1] JP2008-270685A

### [Summary of the Invention]

### [Problems to be solved by the Invention]

The thermoplastic resin layer formed of polypropylene in the back surface solar cell protective sheet disclosed in Patent Literature 1 may have a certain degree of insulation property. However, the adhesive layer formed of a maleic acid anhydride modified polypropylene resin may have poor adhesiveness to the substrate, so that the substrate and the thermoplastic resin layer may delaminate from each other to result in a problem that water vapor permeates into the interior of the solar cell module.

The present invention has been created in view of such circumstances, and objects of the present invention include providing a solar cell protective sheet that has excellent adhesiveness between the substrate and the thermoplastic resin layer and has sufficient insulation property, providing a method for producing the same, and providing a solar cell module that has excellent adhesiveness between the substrate and the thermoplastic layer and has sufficient insulation property.

### [Means for solving the Problems]

To achieve the above objects, first, the present invention provides a solar cell protective sheet comprising a substrate and a thermoplastic resin layer laminated on at least one surface of the substrate, wherein the thermoplastic resin layer comprises: a first layer laminated on the substrate and containing as a main component a copolymer of ethylene and at least one selected from the group consisting of (meth)acrylic acid, (meth)acrylic acid ester, glycidyl (meth)acrylate, vinyl acetate and maleic acid anhydride; a second layer laminated on the first layer and containing an olefin-based resin as a main component; and a third layer laminated on the second layer and containing as a main component a copolymer of ethylene and at least one selected from the group consisting of (meth)acrylic acid, (meth)acrylic acid ester, glycidyl (meth)acrylate, vinyl acetate and maleic acid anhydride (Invention 1).

The solar cell protective sheet according to the above invention (Invention 1) has excellent adhesiveness between the substrate and the thermoplastic resin layer due to the presence of the first layer, has sufficient insulation property due to the presence of the second layer, and exhibits high adhesion to an encapsulant for solar cells due to the presence of the third layer.

In the above invention (Invention 1), it is preferred that the first layer and the third layer has a thickness of 5 to 100 µm, respectively, and the second layer has a thickness of 10 to 300 µm (Invention 2).

In the above inventions (Inventions 1, 2), it is preferred that a total content of (meth)acrylic acid, (meth)acrylic acid ester, glycidyl (meth)acrylate, vinyl acetate and maleic acid anhydride as a monomer unit in each of the copolymers of the first layer and the third layer is 2 to 40 mass% (Invention 3).

In the above inventions (Inventions 1-3), it is preferred that (meth)acrylic acid ester as a monomer unit in each of the copolymers of the first layer and the third layer is at least one selected from the group consisting of methyl (meth)acrylate, ethyl (meth)acrylate, butyl (meth)acrylate, propyl (meth)acrylate and 2-ethylhexyl (meth)acrylate (Invention 4).

In the above inventions (Inventions 1-4), it is preferred that the olefin-based resin of the second layer contains 60 to 100 mass% of ethylene as a monomer unit (Invention 5).

In the above inventions (Inventions 1-5), it is preferred that the olefin-based resin of the second layer has a density of 875 to 920 kg/m³ and a heat of fusion ΔH measured with a differential scanning calorimeter of 100 J/g or less (Invention 6).

In the above inventions (Inventions 1-6), it is preferred that the thermoplastic resin layer is formed by co-extrusion coating of the first layer, the second layer and the third layer (Invention 7).

In the above inventions (Inventions 1-7), it is preferred that the thermoplastic resin layer is a layer to be adhered to an encapsulant that constitutes a solar cell module (Invention 8).

Second, the present invention provides a producing method of a solar cell protective sheet comprising a substrate and a thermoplastic resin layer laminated on at least one surface of the substrate comprising: co-extrusion coating a first resin composition, a second resin composition and a third resin composition onto at least one surface of the substrate so that the second resin composition is interposed between the first and third resin compositions, the first resin composition comprising as a main component a copolymer of ethylene and at least one selected from the group consisting of (meth)acrylic acid, (meth)acrylic acid ester, glycidyl (meth)acrylate, vinyl acetate and maleic acid anhydride, the second resin composition comprising an olefin-based resin as a main component, the third resin composition comprising as a main component a copolymer of ethylene and at least one selected from the group consisting of (meth)acrylic acid, (meth)acrylic acid ester, glycidyl (meth)acrylate, vinyl acetate and maleic acid anhydride; then forming the thermoplastic resin layer comprising: a first layer laminated on the substrate and comprising the first resin composition; a second layer laminated on the first layer and comprising the second resin composition; and a third layer laminated on the second layer and comprising the third resin composition (Invention 9).

Third, the present invention provides a solar cell module comprising a solar cell, an encapsulant that encapsulates the solar cell, and a protective sheet laminated on the encapsulant, wherein the protective sheet comprises the solar cell protective sheet (Invention 8), and the protective sheet is adhered to the encapsulant via the thermoplastic resin layer (Invention 10).

### [Advantageous Effect of the Invention]

The solar cell protective sheet according to the present invention has excellent adhesiveness between the substrate and the thermoplastic resin layer and has sufficient insulation property. According to the method for producing a solar cell protective sheet, the protect sheet for solar cells exhibiting excellent advantageous effects as the above can be obtained. The solar cell module according to the present invention has excellent adhesiveness between the substrate and the thermoplastic resin layer and has sufficient insulation property.

### [Brief Description of Drawings]

[FIG. 1] FIG. 1 is a schematic cross-sectional view of a solar cell protective sheet according to one embodiment of the present invention.
[FIG. 2] FIG. 2 is a schematic cross-sectional view of a solar cell protective sheet according to another embodiment of the present invention.
[FIG. 3] FIG. 3 is a schematic cross-sectional view of a solar cell protective sheet according to another embodiment of the present invention.
[FIG. 4] FIG. 4 is a schematic cross-sectional view of a solar cell protective sheet according to another embodiment of the present invention.
[FIG. 5] FIG. 5 is a schematic cross-sectional view of a solar cell protective sheet according to another embodiment of the present invention.
[FIG. 6] FIG. 6 is a schematic cross-sectional view of a solar cell module according to one embodiment of the present invention.
[FIG. 7] FIG. 7 is a schematic cross-sectional view of a solar cell module according to another embodiment of the present invention.

### [Embodiments for Carrying out the Invention]

Embodiments of the present invention will hereinafter be described.

### «Solar cell protective sheet»

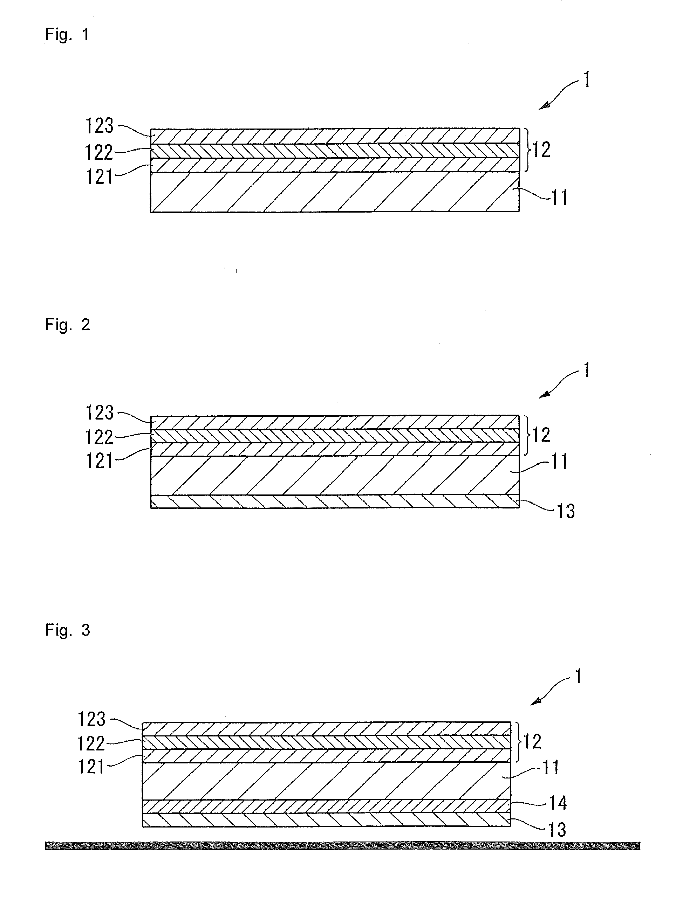

As shown in FIG. 1, solar cell protective sheet 1 according to the present embodiment comprises a substrate 11 and a thermoplastic resin layer 12 laminated on one surface (upper surface in FIG. 1) of the substrate 11. This solar cell protective sheet 1 may be used as a front surface protective sheet (front sheet) or a back surface protective sheet (back sheet) of a solar cell module.

The substrate 11 may be sufficient in general if it has electrical insulation property and is capable of being laminated thereon with the thermoplastic resin layer 12, and those mainly comprised of resin films may typically be used.

The resin film used for the substrate 11 may be selected from resin films commonly used in back sheets for solar cell modules. Such resin films include films or sheets comprising, for example, polyolefin-based resin such as polyethylene and polypropylene, polyester-based resin such as polyethylene terephthalate (PET) and polyethylene naphthalate, polyamide-based resin such as nylon (trade name), polycarbonate-based resin, polystyrene-based resin such as atactic polystyrene and syndiotactic polystyrene (SPS), polyacrylonitrile-based resin, polyvinyl chloride-based resin, polyvinyl acetal-based resin, polyphenylene sulfide resin, polyphenylene ether resin, and/or other appropriate resin. Among these resin films, a film comprising polyester-based resin is preferable, and a PET film is particularly preferable.

The above resin film may contain, as necessary, various additives, such as pigment, ultraviolet absorber, ultraviolet stabilizer, flame retardant, plasticizer, antistatic agent, lubricant, and antiblocking agent. The pigment includes, for example, titanium dioxide, carbon black and other appropriate materials. The ultraviolet absorber includes, for example, benzophenone-based, benzotriazole-based, oxanilide-based, cyanoacrylate-based, and triazine-based ones.

If the solar cell protective sheet 1 according to the present embodiment is used as a back sheet of a solar cell module, it may be preferred that the resin film contains pigment that reflects visible light. If the solar cell protective sheet 1 according to the present embodiment is used as a front sheet of a solar cell module, then the resin film may preferably not contain pigment that reduces transmissivity for light within visible light region, and more preferably may contain ultraviolet absorber for the purpose of improving the weatherability.

In order to improve peel resistance from the thermoplastic resin layer 12, the surface of the resin film to be laminated thereon with the thermoplastic resin layer 12 may preferably be subjected to surface treatment, such as corona treatment, plasma treatment and primer treatment.

The thickness of the substrate 11 may appropriately be set on the basis of the electrical insulation property required for the solar cell module. For example, when the substrate 11 is a resin film, it may be preferred that the thickness thereof is 10 to 300 µm. More specifically, when the substrate 11 is a PET film, in view of the electrical insulation property and the weight saving, the thickness thereof may be preferably 10 to 300 µm, more preferably 20 to 250 µm, and most preferably 30 to 200 µm.

The thermoplastic resin layer 12 in the present embodiment is a layer for causing the solar cell protective sheet 1 to adhere to the sealant of the solar cell module, but the present invention is not limited thereto. The thermoplastic resin layer 12 in the present embodiment may be configured of a first layer 121 laminated on the substrate 11, a second layer 122 laminated on the first layer 121, and a third layer 123 laminated on the second layer 122.

Each of the first layer 121 and the third layer 123 contains, as the main component, a copolymer of ethylene and at least one selected from the group consisting of (meth)acrylic acid, (meth)acrylic acid ester, glycidyl (meth)acrylate, vinyl acetate and maleic acid anhydride (the copolymer may hereinafter be referred to as "copolymer F"). The copolymer F in the first layer 121 and the copolymer F in the third layer 123 may be or may not be the same. The term of (meth)acrylic acid as used herein means both acrylic acid and methacrylic acid. The same applies to other similar terms.

The first layer 121 configured of the above material may exhibit a large adhesion to the substrate 11, particularly to the substrate 11 comprising a resin film, and further to the substrate 11 comprising a PET film. Therefore, the solar cell protective sheet 1 according to the present embodiment has excellent adhesiveness between the substrate 11 and the thermoplastic resin layer 12. The third layer 123 configured of the above material may have high affinity with the encapsulant of the solar cell module, in particular with an encapsulant formed of ethylene-vinyl acetate copolymer which is the same ethylene-based, and thus exhibit a large adhesion to the encapsulant. These large adhesions may ensure that the solar cell protective sheet 1 according to the present embodiment is unlikely to delaminate in itself and to be delaminated from the encapsulant. Therefore, the solar cell protective sheet 1 according to the present embodiment can protect the interior of the solar cell module for long period of time.

Each of the first layer 121 and the third layer may contain, as the main component, the above copolymer F, preferably a copolymer of ethylene and (meth)acrylic acid, a copolymer of ethylene and (meth)acrylic acid ester, or a copolymer of ethylene and vinyl acetate, and particularly preferably a copolymer of ethylene and (meth)acrylic acid ester or a copolymer of ethylene and vinyl acetate, among which one may be solely used or two or more may be used in combination.

The alkyl (meth)acrylate ester may include preferably alkyl (meth)acrylate ester having the carbon number of the alkyl group is 1 to 18, for examples, methyl (meth)acrylate, ethyl (meth)acrylate, butyl (meth)acrylate, propyl (meth)acrylate, and 2-ethylhexyl (meth)acrylate. Among them, methyl acrylate and butyl acrylate may be preferable. One of them may be solely used or two or more may be used in combination.

The total content of (meth)acrylic acid, (meth)acrylic acid ester, glycidyl (meth)acrylate, vinyl acetate and maleic acid anhydride as a monomer unit in the above copolymer F may be preferably 2 to 40 mass%, and particularly preferably 3 to 35 mass%. More specifically, the content of (meth)acrylic acid in the copolymer of ethylene and (meth)acrylic acid, the content of (meth)acrylic acid ester in the copolymer of ethylene and (meth)acrylic acid ester, the content of glycidyl (meth)acrylate in the copolymer of ethylene and glycidyl (meth)acrylate, the content of vinyl acetate in the copolymer of ethylene and vinyl acetate, and/or the content of maleic acid anhydride in the copolymer of ethylene and maleic acid anhydride, may be preferably 2 to 40 mass%, and more preferably 3 to 35 mass%.

The total content of (meth)acrylic acid, (meth)acrylic acid ester, glycidyl (meth)acrylate, vinyl acetate and maleic acid anhydride may be within the above range thereby to result in that the previously-described large adhesion to the substrate 11 will be more significant. If the total content of (meth)acrylic acid, (meth)acrylic acid ester, glycidyl (meth)acrylate, vinyl acetate and maleic acid anhydride is less than 2 mass%, then adhesion to the substrate 11, the second layer 122 and the encapsulant may be reduced, while if the total content is 40 mass% or more, then sufficient aggregation force cannot be obtained and irregularities in winding may possibly occur when the solar cell protective sheet 1 is rolled up.

The first layer 121 and the third layer 123 may be sufficient if the above copolymer F is contained as the main component, in particular, preferably contained with 60 mass% or more, particularly preferably with 80 mass% or more, and further preferably with 90 mass% or more. The first layer 121 may consist only of the copolymer F.

The second layer 122 contains an olefin-based resin as the main component. Olefin-based resin may have sufficient insulation property, and in particular may exhibit higher insulation property compared to that of the above copolymer F. Performance of insulation may be such that the partial discharge voltage is preferably 1,000 V or higher, and particularly preferably 1,050 V or higher. The partial discharge voltage may be a value measured according to IEC 60664-1. According to the solar cell protective sheet 1 having the second layer 122 with such excellent insulation property, the solar cell module can be prevented from deterioration in power generation capability due to insulation failure.

The olefin-based resin in the second layer 122 include, for example, polyethylene resin such as very low density polyethylene (VLDPE, density: 880 kg/m³ or more and less than 910 kg/m³), low density polyethylene (LDPE, density: 910 kg/m³ or more and less than 930 kg/m³), middle density polyethylene (MDPE, density: 930 kg/m³ or more and less than 942 kg/m³) and high density polyethylene (HDPE, density: 942 kg/m³ or more), polypropylene resin (PP), polyethylene-polypropylene copolymer, olefin-based elastomer (TPO), cycloolefin resin, ethylene-vinyl acetate copolymer (EVA), ethylene-vinyl acetate-maleic anhydride copolymer, ethylene-(meth)acrylic acid copolymer, ethylene-(meth)acrylic acid ester copolymer, and ethylene-(meth)acrylic acid ester-maleic anhydride copolymer, among which one may be solely used or two or more may be mixed and used.

Among the above olefin-based resins, polyethylene-based resin may be preferable which contains 60 to 100 mass%, particularly 70 to 99.5 mass% of ethylene as a monomer unit. In particular, such a polyethylene-based resin may have excellent insulation property. From the view point of suppressing the solar cell protective sheet 1 from curling, very low density polyethylene and low density polyethylene may be preferable which have lower contraction ratio even when cooled from the heated and molten state, and very low density polyethylene may particularly be preferable.

The above olefin-based resin may have the density of preferably 875 to 920 kg/m³, and particularly preferably 880 to 915 kg/m³. The heat (or enthalpy) of fusion ΔH measured with a differential scanning calorimeter is preferably 100 J/g or less, and particularly preferably 95 J/g or less. The density may be a value obtained by measurement according to JIS K7112: 1999.

Olefin-based resin, which has a low or very low density and a low heat of fusion as described above and thus low crystallinity, is with a significantly small contraction rate even when cooled from the heated and molten state, and hence the solar cell protective sheet 1 according to the present embodiment has less curl amount.

The second layer 122 may be sufficient if olefin-based resin is contained as the main component, in particular, preferably contained with 60 mass% or more, particularly preferably with 80 mass% or more, and further preferably with 90 mass% or more. Of course, the second layer 122 may consist only of the olefin-based resin.

Melt flow rate (MFR) of the copolymer F in each of the first layer 121 and the third layer and the olefin-based resin in the second layer 122 may be preferably within a range of 1 to 20 g/10 min, and particularly preferably within a range of 2 to 10 g/10 min. The MFR of both resins being within the above range may allow the first layer 121, the second layer 122 and the third layer 123 to be formed by co-extrusion coating.

The first layer 121, the second layer 122 and the third layer 123 may contain, as necessary, in addition to the above resin as the main component, various additives, such as pigment, ultraviolet absorber, ultraviolet stabilizer, flame retardant, plasticizer, antistatic agent, lubricant, and antiblocking agent. If, however, the first layer 121 or the third layer 123 contains pigment, then adhesiveness may deteriorate so that peel resistance from the substrate 11 or the encapsulant may possibly be poor, and hence it may be preferred that the first layer 121 and the third layer are free from pigment. It may also be preferred that the second layer 122 is free from electrically-conductive additives.

The thickness of the first layer 121 and the third layer 123 may not particularly be restricted so long as exhibiting desired adhesiveness to the substrate 11 or the encapsulant without impairing the advantageous effects of the present invention. More specifically, the thickness of the first layer 121 and the third layer 123 may be preferably 5 to 100 µm, particularly preferably 5 to 70 µm, and further preferably 10 to 50 µm.

The thickness of the second layer 122 may not particularly be restricted so long as exhibiting desired insulation property without impairing the advantageous effects of the present invention. More specifically, the thickness of the second layer 122 may be preferably 10 to 300 µm, particularly preferably 30 to 200 µm, and further preferably 50 to 150 µm. Considering the balance between adhesiveness of the first layer 121 and the third layer 123 and insulation property of the second layer 122, the thickness of the second layer may be preferably 30-95% of that of the thermoplastic resin layer 12, particularly preferably 40-90%, and further preferably 45-80%.

The thermoplastic resin layer 12 in the present embodiment may consist of the first layer 121, the second layer 122 and the third layer 123, but the present invention is not limited thereto, and one or more additional layers may be provided so long as not impairing the advantageous effects of the present invention. For example, a fourth layer may be provided between the first layer 121 and the second layer 122 or between the second layer 122 and the third layer 123.

As shown in FIG. 2, it may be preferred that a fluorine resin layer 13 is provided on the surface (lower surface in FIG. 2) of the substrate 11 at the side where the above thermoplastic resin layer 12 is not laminated. Providing the fluorine resin layer 13 in such a manner may improve the weatherability and chemical resistance of the solar cell protective sheet 1. When the substrate 11 is formed of a resin film, the surface of the resin film to be laminated thereon with the fluorine resin layer 13 may preferably be subjected to surface treatment, such as corona treatment, plasma treatment and primer treatment, in order to improve peel resistance from the fluorine resin layer 13.

The fluorine resin layer 13 is not particularly restricted if containing fluorine, and may be configured of a sheet having fluorine-containing resin (fluorine-containing resin sheet) or a coating obtained by applying a paint that includes fluorine-containing resin, for example. Among them, the coating obtained by applying a paint that includes fluorine-containing resin may be preferable in view of reducing the thickness of the fluorine resin layer 13 for the purpose of weight saving of the solar cell protective sheet 1.

The fluorine-containing resin sheet includes, for example, a sheet-like resin mainly containing polyvinyl fluoride (PVF), ethylene-chlorotrifluoroethylene (ECTFE) or ethylene-tetrafluoroethylene (ETFE). The resin mainly containing PVF include, for example, "Tedlar" (trade name) available from E. I. du Pont de Nemours and Company. Examples of the resin that contains ECTFE as the main component include "Halar" (trade name) available from Solvay Solexis, Inc. The resin mainly containing ETFE includes, for example, "Fluon" (trade name) available from ASAHI GLASS CO., LTD.

If the fluorine resin layer 13 is a fluorine-containing resin sheet, the fluorine resin layer 13 may be laminated on the substrate 11 via an adhesive layer. The adhesive layer may be comprised of an adhesive that has adhesiveness to the substrate 11 and the fluorine-containing resin sheet. Such adhesive include, for example, acrylic-based adhesive, polyurethane-based adhesive, epoxy-based adhesive, polyester-based adhesive, and polyester polyurethane-based adhesive. One of these adhesives may be solely used or two or more may be used in combination.

If the fluorine resin layer 13 is a coating obtained by applying a paint that includes fluorine-containing resin, then the fluorine resin layer 13 may be laminated on the substrate 11 by applying the paint, which contains fluorine-containing resin, directly to the substrate 11 ordinarily without any adhesive layer.

The paint that contains fluorine-containing resin is not particularly limited if being dissolved into solvent or dispersed into water and capable of being applied.

The fluorine-containing resin contained in the paint is not particularly limited if being a resin that contains fluorine without impairing the advantageous effects of the present invention, and a resin may ordinarily be used which dissolves into solvent of the paint (organic solvent or water) and which is crosslinkable. Examples of crosslinkable functional group include hydroxyl group, carboxyl group, amino group, and glycidyl group.

Specific examples of fluoroolefin resin having crosslinkable functional group include polymers, such as "LUMIFLON" (trade name) available from ASAHI GLASS CO., LTD, "CEFRAL COAT" (trade name) available from Central Glass Co., Ltd. and "FLUONATE" (trade name) available from DIC Corporation, which contain chlorotrifluoroethylene (CTFE) as the main component, and polymers, such as "ZEFFLE" (trade name) available from DAIKIN INDUSTRIES, LTD, which contain tetrafluoroethylene (TFE) as the main component. Among them, in view of weatherability and pigment dispersibility, etc., a polymer that contains CTFE as the main component and a polymer that contains TFE as the main component may be preferred, and "LUMIFLON" and "ZEFFLE" may particularly be preferred.

The paint may contain cross-linking agent, curing catalyst, solvent and other appropriate agents in addition to the above fluorine-containing resin, and may further contain inorganic compounds, such as pigment and filler, if necessary.

Solvent contained in the paint is not particularly limited so long as not impairing the advantageous effects of the present invention, and solvent may preferably be used which contains one or more of organic solvent selected from methyl ethyl ketone (MEK), cyclohexanone, acetone, methyl isobutyl ketone (MIBK), toluene, xylene, methanol, isopropanol, ethanol, heptane, ethyl acetate, isopropyl acetate, n-butyl acetate, or n-butyl alcohol.

The coating of the fluorine-containing resin may preferably be crosslinked by using a cross-linking agent in order to improve the weatherability and abrasion-resistant ability. The cross-linking agent is not particularly limited so long as not impairing the advantageous effects of the present invention, and metal chelates, silanes, isocyanates or melamines may preferably be used. On the assumption that the solar cell protective sheet 1will be placed outdoors and used for long period of time, aliphatic isocyanates of cross-linking agent may be preferable in view of weatherability.

Any known method may be used as the method of applying the paint to the substrate 11, and the paint may be applied to the substrate 11 so that the fluorine resin layer 13 with desired thickness is obtained, for example, using bar-coating, knife-coating, roll-coating, blade-coating, die-coating, gravure-coating, or other appropriate method.

The thickness of the fluorine resin layer 13, which will be set with consideration for the weatherability, chemical resistance, weight saving and other factors, may be preferably 5 to 50 µm, and particularly preferably 10 to 30 µm.

The fluorine resin layer 13 may also be comprised of thermoplastic material, in which case the fluorine resin layer 13 can be formed by extrusion coating method rather than by application of a paint. Such a fluorine resin layer 13 may be formed directly on the substrate 11 by extrusion coating, or otherwise formed on the substrate 11 via one or more additional layers that can enhance the adhesion to the substrate 11. For example, as shown in FIG. 3, a second thermoplastic resin layer 14 may be interposed between the fluorine resin layer 13 and the substrate 11. In this case, co-extrusion coating may preferably be performed such that the second thermoplastic resin layer 14 and the fluorine resin layer 13 are formed on the substrate 11.

The fluorine resin layer 13 comprising thermoplastic material include, for example, resins mainly containing ethylene-tetrafluoroethylene-based copolymer (ETFE), ethylene-chlorotrifluoroethylene-based copolymer, ethylene-tetrafluoroethylene-hexafluoropropylene-based copolymer, tetrafluoroethylene-perfluoro (alkyl vinyl ether)-based copolymer, tetrafluoroethylene-hexafluoropropylene-based copolymer, tetrafluoroethylene-perfluoro (alkyl vinyl ether)-hexafluoropropylene-based copolymer or other copolymer, or modified polymer thereof. One of these resins may be solely used or two or more may be mixed and used. The fluorine resin layer 13 comprising thermoplastic material may have high weatherability as advantages. Among the above resins, ETFE may particularly be preferable in view of peel resistance from the substrate 11 or to the second thermoplastic resin layer 14.

The second thermoplastic resin layer 14 include, for example, polyethylene such as low density polyethylene (LDPE, density: 910 kg/m³ or more and less than 930 kg/m³), middle density polyethylene (MDPE, density: 930 kg/m³ or more and less than 942 kg/m³) and high density polyethylene (HDPE, density: 942 kg/m³ or more), polypropylene (PP), olefin-based elastomer (TPO), cycloolefin-based resin, ethylene-vinyl acetate copolymer (EVA), ethylene-vinyl acetate-maleic anhydride copolymer, ethylene-(meth)acrylic acid copolymer, ethylene-(meth)acrylic acid ester-maleic anhydride copolymer, and ethylene-glycidyl (meth)acrylate copolymer. Among them, ethylene-vinyl acetate-maleic anhydride copolymer and ethylene-glycidyl methacrylate copolymer (EGMA) may be more preferable. One of these resins may be solely used or two or more may be mixed and used. The above resin has a functional group and therefore polarity, thus exhibiting large adhesion to the substrate 11, particularly to the substrate 11 comprising a resin film, and further to the substrate 11 comprising a PET film. Among the above resins, EGMA may particularly be preferable because of excellent adhesiveness both to the fluorine resin layer 13, which comprises fluorine resin that contains a functional group, and to the substrate 11 comprising PET etc.

The thickness of the second thermoplastic resin layer 14 is not particularly restricted so long as exhibiting desired adhesiveness to the substrate 11 without impairing the advantageous effects of the present invention. More specifically, the thickness of the second thermoplastic resin layer 14 may be preferably 2 to 100 µm, particularly preferably 5 to 75 µm, and further preferably 10 to 50 µm.

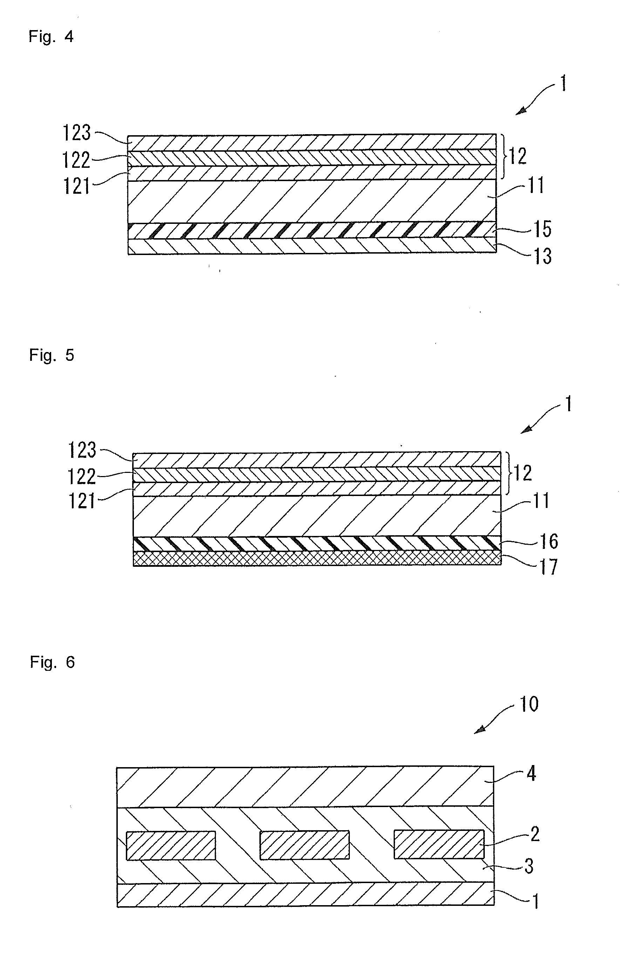

The surface of the substrate 11 at the side where the above thermoplastic resin layer 12 is not laminated may be provided with a vapor-deposited layer 15 between the substrate 11 and the fluorine resin layer 13 as shown in FIG. 4, or provided with a metal sheet 17 via an adhesive layer 16 as shown in FIG. 5, or the above-described fluorine resin layer 13 may also be provided on the surface of the vapor-deposited layer 15 or the metal sheet 17 (each lower surface in FIG. 4 and FIG. 5). Providing the vapor-deposited layer 15 or the metal sheet 17 in such a manner may improve the moisture-proof property and the weatherability of the solar cell protective sheet 1.

If the substrate 11 is formed of a resin film, the surface of the resin film at the side where the vapor-deposited layer 15 or the adhesive layer 16 is laminated thereon may preferably be subjected to surface treatment, such as corona treatment, plasma treatment and primer treatment, in order to improve peel resistance from the vapor-deposited layer 15 or the adhesive layer 16.

The vapor-deposited layer 15 may comprise inorganic material, such as metal or semimetal, oxide of metal or semimetal, nitride and silicide, thereby the substrate 11 (solar cell protective sheet 1) may have the moisture-proof property (water vapor barrier property) and the weatherability.

The vapor deposition method used for forming the vapor-deposited layer 15 include, for example, chemical vapor phase method such as plasma-enhanced chemical vapor deposition method, thermochemical vapor deposition method and photochemical vapor deposition method, and physical vapor phase method such as vacuum vapor deposition method, sputtering method and ion plating method. Among these methods, vacuum vapor deposition method may be preferable in consideration of operability and controllability for the layer thickness.

The metal to be raw material for the vapor-deposited layer 15 include, for example, aluminum (Al), magnesium (Mg), calcium (Ca), potassium (K), tin (Sn), sodium (Na), titanium (Ti), lead (Pb), zirconium (Zr), and yttrium (Y). Examples of semimetal include silicon (Si) and boron (B). The oxide, nitride and oxynitride of these metals or semimetals include, for example, aluminum oxide, tin oxide, silicon oxide, silicon nitride, silicon oxynitride, and aluminum oxynitride.

The vapor-deposited layer 15 may comprise one of inorganic material or plural of inorganic materials. The vapor-deposited layer 15 comprised of plural of inorganic materials may be vapor-deposited layers of a laminated structure in which each layer of inorganic material is sequentially vapor deposited, or a vapor-deposited layer in which the plural of inorganic materials are concurrently vapor-deposited.

The thickness of the vapor-deposited layer 15 may appropriately be set with consideration for the water vapor barrier property and changed depending on the inorganic material used, vapor deposition density and other factors. Typically, the thickness of the vapor-deposited layer 15 may be preferably 5 to 200 nm, and particularly preferably 10 to 100 nm.

Like the vapor-deposited layer 15, the metal sheet 17 may also allow the substrate 11 (solar cell protective sheet 1) to have the moisture-proof property (water vapor barrier property) and the weatherability. Material for the metal sheet 17 is not particularly restricted so long as having such functions, and examples thereof include aluminum, aluminum alloy such as aluminum-iron alloy, and other appropriate metals.

While the thickness of the metal sheet 17 is not particularly limited so long as not impairing the advantageous effects of the present invention, the thickness may be preferably 5 to 100 µm, and particularly preferably 10 to 50 µm, from the aspect of lower occurrence frequency of pinholes, higher mechanical strength, higher water vapor barrier property, weight saving and other factors.

The adhesive layer 16 may comprise an adhesive that has adhesiveness to the substrate 11 and the metal sheet 17. Examples of the adhesive used for constituting the adhesive layer 16 include acrylic-based adhesive, polyurethane-based adhesive, epoxy-based adhesive, polyester-based adhesive, and polyester polyurethane-based adhesive. One of these adhesives may be solely used or two or more may be used in combination.

While the thickness of the adhesive layer 16 is not particularly limited so long as not impairing the advantageous effects of the present invention, typically the thickness may be preferably 1 to 20 µm, and particularly preferably 3 to 10 µm.

The above embodiments may have exemplified the solar cell protective sheet 1in which the thermoplastic resin layer 12 is laminated on one surface of the substrate 11, but the solar cell protective sheet of the present invention is not limited thereto, and a thermoplastic resin layer may also be laminated on the other surface of the substrate 11 (opposite surface to the above one surface).

### «Producing method of solar cell protective sheet»

In order to produce the solar cell protective sheet 1 according to the present embodiment (as one example, the solar cell protective sheet 1shown in FIG. 1), it may be preferred to perform co-extrusion coating of a first resin composition that constitutes the first layer 121 of the thermoplastic resin layer 12, a second resin composition that constitutes the second layer 122 and a third resin composition that constitutes the third layer 123 onto at least one surface of the substrate 11 so that the second resin composition is interposed between the first resin composition and the third resin composition and the first resin composition is located at the side of the substrate 11, thereby to form the thermoplastic resin layer 12 comprising the first layer 121 laminated on the substrate 11, the second layer 122 laminated on the first layer 121 and the third layer 123 laminated on the second layer 122. Such a co-extrusion coating method may allow the solar cell protective sheet 1 produced with high productivity at low cost. Since an adhesive layer needs not be separately provided for causing the solar cell protective sheet 1 to adhere to the encapsulant of the solar cell module, time degradation such as due to decomposition of that adhesive can be prevented.

Specifically, using a T-die film forming machine or the like, the first, second and third resin compositions are respectively mixed and molten with constant speed, then the molten first, second and third resin compositions are co-extruded to laminate, then to form the thermoplastic resin layer 12 comprising the first layer 121, the second layer 122 and the third layer 123 on the substrate 11, and then to obtain solar cell protective sheet 1.

If one or more additional layers are formed on the substrate 11 as shown in FIG. 2 to FIG. 5, the thermoplastic resin layer 12 may be formed on the surface at the side where the one or more additional layers are not formed.

Temperature for melting the first to third resin compositions that form the thermoplastic resin layer 12 may be set as being such a degree that does not deform the substrate 11 due to the temperature (heat) of the molten resin compositions, and the temperature may be preferably 80°C to 350°C, and particularly preferably 150°C to 300°C.

Discharge rates from the T-die film forming machine for the first to third resin compositions that form the thermoplastic resin layer 12 may appropriately be adjusted depending on the intended thicknesses of the first to third layers 121, 122 and 123 of the thermoplastic resin layer 12 and/or the moving speed of the substrate 11.

The substrate 11 may be moved (carried) in the longitudinal direction with constant speed by roll-to-roll process, for example, and the moving speed may appropriately be adjusted depending on the discharge rates from the T-die film forming machine for the first to third resin compositions that form the thermoplastic resin layer 12.

According to the co-extrusion coating method described above, the thermoplastic resin layer 12 can be tightly bonded to the substrate 11 simply by performing the co-extrusion coating of the molten first to third resin compositions from the T-die film forming machine to be laminated on one surface of the substrate 11, and the solar cell protective sheet 1can thus be produced with high productivity.

### «Solar cell module»

FIG. 6 is a schematic cross-sectional view of a solar cell module according to one embodiment of the present invention. Solar cell module 10 according to the present embodiment may be configured of: plural solar cells 2 as photoelectric conversion elements, each comprising crystal silicon, amorphous silicon and/or other appropriate material; an encapsulant (filling layer) 3, comprising electrical insulator, which encapsulates the solar cells 2; a glass plate 4 laminated on the front surface (upper surface in FIG. 6) of the encapsulant 3; and the solar cell protective sheet 1, as a back surface protective sheet (back sheet), laminated on the back surface (lower surface in FIG. 6) of the encapsulant 3.

The solar cell protective sheet 1may be laminated on the encapsulant 3 so that the third layer 123 of the thermoplastic resin layer 12 is located at the side of the encapsulant 3, and hence the thermoplastic resin layer 12 may ensure the large adhesion to the encapsulant 3. As previously described, the solar cell protective sheet 1 according to the present embodiment may have excellent adhesiveness between the substrate 11 and the thermoplastic resin layer 12. Due to these large adhesions, the interior of the solar cell module 10 according to the present embodiment can be protected by the solar cell protective sheet 1 for long period of time. The solar cell protective sheet 1 according to the present embodiment may be such that the second layer 122 of the thermoplastic resin layer 12 contributes to excellent insulation property, and hence the solar cell module 10 can be prevented from deterioration in power generation capability due to insulation failure by using the solar cell protective sheet 1. The solar cell protective sheet 1 according to the present embodiment may also exhibit less curl amount, so that the obtained solar cell module 10 can be suppressed from warping. Consequently, the solar cell module 10 can be prevented from troubles that may occur at the time of installing the solar cell module 10, and/or from being damaged, due to the warpage of the solar cell module 10.

Material for the encapsulant 3 may preferably be olefin-based resin, such as ethylene-based resin exemplified as the main component in the third layer 123 of the thermoplastic resin layer 12, and more preferably ethylene-vinyl acetate copolymer (EVA) in view of high gas barrier property for oxygen and other problematic gasses, easy cross-linkage, and availability etc. The material for the encapsulant 3 being olefin-based resin, in particular ethylene-based resin, may ensure the high affinity with the third layer 123, which contains ethylene-based resin as the main component, of the thermoplastic resin layer 12, thereby further enhancing the adhesion between the thermoplastic resin layer 12 and the encapsulant 3.

Producing method of the above solar cell module 10 may not be particularly limited, and the solar cell module 10 can be produced, for example, through: interposing the solar cells 2 between two sheets that constitute the encapsulant 3; placing the solar cell protective sheet 1 on one exposed surface of those sheets; placing the glass plate 4 on the other exposed surface of those sheets; and integrating them by pressing while heating them. According to this method, the solar cell protective sheet 1 may be bonded to the encapsulant 3 by the thermal fusion bonding between the thermoplastic resin layer 12 and the encapsulant 3.

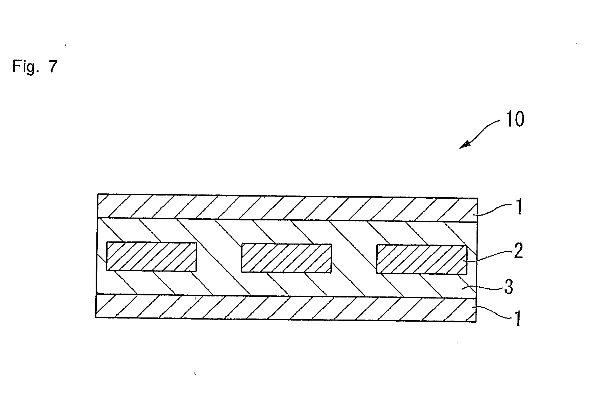

As shown in FIG. 7, a protective sheet 1 for solar cells as the front surface protective sheet (front sheet) may be used as a substitute for the glass plate 4. In this case, if flexible substrates are used for the solar cells 2, a solar cell module that has flexibility can be obtained. Causing the solar cell module to have flexibility in such a manner may enable mass production via roll-to-roll process. As the solar cell module having flexibility can be fitted to an object that has arch-shaped or parabolic-shaped wall surface, the solar cell module can be installed on domed buildings or sound abatement walls of expressway.

It should be appreciated that the embodiments heretofore explained are described to facilitate understanding of the present invention and are not described to limit the present invention. Therefore, it is intended that the elements disclosed in the above embodiments include all design changes and equivalents to fall within the technical scope of the present invention.

### [Examples]

The present invention will hereinafter be described further specifically with reference to examples etc., but the scope of the present invention is not limited to these examples etc.

### «Example 1»

One surface of a PET film (Lumirror X10S available from Toray Industries, Inc., thickness 125 µm) as a substrate was subjected to corona treatment (output 2,000 W). Using a T-die film forming machine (cylinder temperature: 230°C to 280°C, T-die temperature: 300°C), ethylene-butyl acrylate copolymer (trade name: LOTRYL 17BA07, available from Arkema, content of butyl acrylate: 17 mass%, referred hereinafter to as "copolymer A"), very low density polyethylene-based resin (trade name: LUMITAC 43-1, available from TOSOH CORPORATION, density 905 kg/m³) containing 15 mass% of titanium oxide, and another copolymer A were co-extruded directly onto the corona treated surface of the above PET film so as to respectively have thicknesses of 15 µm /120 µm /15 µm and sandwich the very low density polyethylene-based resin between copolymers A, thereby to form a thermoplastic resin layer comprising a first layer (copolymer A), a second layer (very low density polyethylene-based resin), and a third layer (copolymer A), then a solar cell protective sheet having the structure shown in FIG. 1 was obtained.

### «Example 2»

A solar cell protective sheet having the structure shown in FIG. 1 was obtained in the same manner as Example 1 with the exception of changing the copolymer A to ethylene-methyl acrylate copolymer (trade name: LOTRYL 28MA07, available from Arkema, content of methyl acrylate: 28 mass%).

### «Example 3»

A solar cell protective sheet having the structure shown in FIG. 1 was obtained in the same manner as Example 1 with the exception of changing the copolymer A to ethylene-methacrylic acid copolymer (NUCREL N1525 available from DUPONT-MITSUI POLYCHEMICALS CO., LTD, content of methacrylic acid: 15 mass%).

### «Example 4»

A solar cell protective sheet having the structure shown in FIG. 1 was obtained in the same manner as Example 1 with the exception of changing the copolymer A to ethylene-vinyl acetate copolymer (ULTRATHENE 750 available from TOSOH CORPORATION, content of vinyl acetate : 32 mass%).

### «Example 5»

A solar cell protective sheet having the structure shown in FIG. 1 was obtained in the same manner as Example 1 with the exception of changing respective layer thicknesses of the first layer (copolymer A), the second layer (very low density polyethylene-based resin) and the third layer (copolymer A) to 40 µm /70 µm /40 µm.

### «Comparative Example 1»

One surface of a PET film (Lumirror X10S available from Toray Industries, Inc., thickness 125 µm) as a substrate was subjected to corona treatment (output 2,000 W). Using a T-die film forming machine (cylinder temperature: 230°C to 280°C, T-die temperature: 300°C), very low density polyethylene-based resin (trade name: LUMITAC 43-1, available from TOSOH CORPORATION, density 905 kg/m³) containing 15 mass% of titanium oxide was extruded directly onto the corona treated surface of the above PET film to form a thermoplastic resin layer having a thickness of 150 µm, then a solar cell protective sheet was obtained.

### «Comparative Example 2»

One surface of a PET film (Lumirror X10S available from Toray Industries, Inc., thickness 125 µm) as a substrate was subjected to corona treatment (output 2,000 W). Using a T-die film forming machine (cylinder temperature: 230°C to 280°C, T-die temperature: 300°C), copolymer A was extruded directly onto the corona treated surface of the above PET film to form a thermoplastic resin layer having a thickness of 150 µm, then a solar cell protective sheet was obtained.

### «Exemplary Test 1» <Test for adhesiveness to PET>

Protective sheets for solar cells obtained in the examples and the comparative examples were each evaluated in terms of adhesiveness of the thermoplastic resin layer to the PET film according to Japan Industrial Standard: JIS K6854-3: 1999 "Determination of peel strength of bonded assemblies -- Part 3: Adhesives -- 180 degree SIGN peel test for flexible-to-flexible bonded assemblies (T-peel test)". Specific procedure is as follows.

A test piece was prepared by cutting each of the protective sheets for solar cells obtained in the examples and the comparative examples into 25 mm×200 mm. This test piece was attached to upper and lower parts of a tensile tester (RTG-1225 available from A&D Company, Limited) so as to allow the substrate and the thermoplastic resin layer peeled off from each other, and the load was measured as an adhesion (N/25 mm) while peeling off one from the other of the test piece with a peeling-off speed of 300 mm/min under a given condition of a temperature of 23°C and a humidity of 50%RH (during the measurement, the pealing-off portion was fixed to have an angle of 180 degrees). Results are shown in Table 1.

### «Exemplary Test 2» <Test for adhesiveness to encapsulant>

Protective sheets for solar cells obtained in the examples and the comparative examples were each evaluated in terms of adhesiveness to an encapsulant according to Japan Industrial Standard: JIS K6854-3: 1999. Specific procedure is as follows.

Protective sheets for solar cells obtained in the examples and the comparative examples were each laminated on an encapsulant (Ultrapearl available from SANVIC Inc., thickness: 400 µm) with the thermoplastic resin layer being located at the encapsulant side, and the encapsulant was laminated on a white plate glass subjected to heat lamination in vacuum. The heat lamination in vacuum was conducted to have a vacuum state at 135°C for 3 minutes and a pressurization state at 135°C for 3 minutes.

Thereafter, the obtained laminated body was heated at 150°C for 30 minutes to crosslink the encapsulant, and a dummy solar cell module was produced. The obtained dummy solar cell module was cut into the solar cell protective sheet with a width of 10 mm, which was set as a test piece to a tensile tester (RTG-1225 available from A&D Company, Limited). The test piece was subjected to peeling-off of 180 degrees with a peeling-off speed of 300 mm/min under a given condition of a temperature of 23°C and a humidity of 50%RH, and the load at that time was measured as an adhesion (N/10 mm). Results are shown in Table 1.

### «Exemplary Test 3» <Partial discharge voltage measurement>

For each of protective sheets for solar cells obtained in the examples and the comparative examples, the partial discharge voltage was measured using a partial discharge voltage tester (KPD 2050 available from KIKUSUI ELECTRONICS CORPORATION) according to IEC 60664-1. Results are shown in Table 1. A partial discharge voltage being 1,000 V or more can be said as representing excellent insulation property.

**[Table 1]**

| | Adhesiveness to PET | Adhesiveness to encapsulant | Partial discharge voltage |
|---|---|---|---|
| | [N/25 mm] | [N/10 mm] | [V] |
| Example 1 | Not peeled off* | 65.0 | 1150 |
| Example 2 | Not peeled off* | 72.5 | 1100 |
| Example 3 | Not peeled off* | 80.0 | 1110 |
| Example 4 | Not peeled off* | 75.0 | 1160 |
| Example 5 | Not peeled off* | 69.5 | 1050 |
| Comparative Example 1 | 14.8 | 35.5 | 1230 |
| Comparative Example 2 | Not peeled off* | 73.0 | 890 |

| | | | |
|---|---|---|---|
| * The peeling-off was not able due to considerably strong adhesion. | | | |

As understood from Table 1, each of the protective sheets for solar cells in the examples had a high adhesion between the substrate (PET film) and the thermoplastic resin layer and a high adhesion between the solar cell protective sheet and the encapsulant, and also had excellent insulation property. In contrast, the solar cell protective sheet in Comparative Example 1, using only polyethylene-based resin as the thermoplastic resin layer, had a low adhesion between the substrate (PET film) and the thermoplastic resin layer and a low adhesion between the solar cell protective sheet and the encapsulant, while the solar cell protective sheet in Comparative Example 2, using only ethylene-butyl acrylate copolymer as the thermoplastic resin layer, had poor insulation property.

### [Industrial Applicability]

The solar cell protective sheet according to the present invention may preferably be utilized as a back sheet of a solar cell module, for example.

### [Explanation of Numeral References]

- 1: Solar cell protective sheet
11 Substrate
12 Thermoplastic resin layer
121 First layer
122 Second layer
123 Third layer
13 Fluorine resin layer
14 Second thermoplastic resin layer
15 Vapor-deposited layer
16 Adhesive layer
17 Metal sheet
- 2: Solar cell
- 3: Encapsulant
- 4: Glass plate
- 10: Solar cell module

## Claims

1. A solar cell protective sheet comprising a substrate and a thermoplastic resin layer laminated on at least one surface of the substrate, wherein
the thermoplastic resin layer comprises:
a first layer laminated on the substrate and containing as a main component a copolymer of ethylene and at least one selected from the group consisting of (meth)acrylic acid, (meth)acrylic acid ester, glycidyl (meth)acrylate, vinyl acetate and maleic acid anhydride;
a second layer laminated on the first layer and containing an olefin-based resin as a main component; and
a third layer laminated on the second layer and containing as a main component a copolymer of ethylene and at least one selected from the group consisting of (meth)acrylic acid, (meth)acrylic acid ester, glycidyl (meth)acrylate, vinyl acetate and maleic acid anhydride.

2. The solar cell protective sheet as set forth in claim 1, wherein
the first layer and the third layer has a thickness of 5 to 100 µm, respectively and
the second layer has a thickness of 10 to 300 µm.

3. The solar cell protective sheet as set forth in claim 1 or 2, wherein a total content of (meth)acrylic acid, (meth)acrylic acid ester, glycidyl (meth)acrylate, vinyl acetate and maleic acid anhydride as a monomer unit in each of the copolymers of the first layer and the third layer is 2 to 40 mass%.

4. The solar cell protective sheet as set forth in either one of claims 1 to 3, wherein (meth)acrylic acid ester as a monomer unit in each of the copolymers of the first layer and the third layer is at least one selected from the group consisting of methyl (meth)acrylate, ethyl (meth)acrylate, butyl (meth)acrylate, propyl (meth)acrylate and 2-ethylhexyl (meth)acrylate.

5. The solar cell protective sheet as set forth in either one of claims 1 to 4, wherein the olefin-based resin of the second layer contains 60 to 100 mass% of ethylene as a monomer unit.

6. The solar cell protective sheet as set forth in either one of claims 1 to 5, wherein the olefin-based resin of the second layer has a density of 875 to 920 kg/m³ and a heat of fusion ΔH measured with a differential scanning calorimeter of 100 J/g or less.

7. The solar cell protective sheet as set forth in either one of claims 1 to 6, wherein the thermoplastic resin layer is formed by co-extrusion coating of the first layer, the second layer and the third layer.

8. The solar cell protective sheet as set forth in either one of claims 1 to 7, wherein the thermoplastic resin layer is a layer to be adhered to an encapsulant that constitutes a solar cell module.

9. A producing method of a solar cell protective sheet comprising a substrate and a thermoplastic resin layer laminated on at least one surface of the substrate comprising:
co-extrusion coating a first resin composition, a second resin composition and a third resin composition onto at least one surface of the substrate so that the second resin composition is interposed between the first and third resin compositions, the first resin composition comprising as a main component a copolymer of ethylene and at least one selected from the group consisting of (meth)acrylic acid, (meth)acrylic acid ester, glycidyl (meth)acrylate, vinyl acetate and maleic acid anhydride, the second resin composition comprising an olefin-based resin as a main component, the third resin composition comprising as a main component a copolymer of ethylene and at least one selected from the group consisting of (meth)acrylic acid, (meth)acrylic acid ester, glycidyl (meth)acrylate, vinyl acetate and maleic acid anhydride; then
forming the thermoplastic resin layer comprising: a first layer laminated on the substrate and comprising the first resin composition; a second layer laminated on the first layer and comprising the second resin composition; and a third layer laminated on the second layer and comprising the third resin composition.

10. A solar cell module comprising a solar cell, an encapsulant that encapsulates the solar cell, and a protective sheet laminated on the encapsulant, wherein
the protective sheet comprises the solar cell protective sheet as set forth in claim 8, and
the protective sheet is adhered to the encapsulant via the thermoplastic resin layer.
